# FASCICULE DE BREVET EUROPEEN

(11) **EP 0 985 334 B1**
(45) Date de publication et mention de la délivrance du brevet: **01.08.2001**
(21) Numéro de dépôt: 98920687.5
(22) Date de dépôt: 28.05.1998
(51) Int. Cl.: H05K 7/10

(54) **ADAPTATEUR POUR COMPOSANTS ELECTRONIQUES**
ADAPTER FÜR ELEKTRONISCHEN BAUTEILE
ELECTRONIC COMPONENT ADAPTER

(30) Priorité: 30.05.1997 CH 127797
(43) Date de publication de la demande: 15.03.2000
(73) Titulaire: Ultra Precision Holding S.A., 1870 Monthey (CH)
(72) Inventeur: LYOTARD, Patrick, CH-1312 Eclepens (CH)
(74) Mandataire: KIRKER & Cie S.A.
(86) Numéro de dépôt international: IB9800829
(87) Numéro de publication internationale: WO9854937

(56) Documents cités:
- WO-A-91/16740
- US-A- 5 046 972

## Description

La présente invention concerne un adaptateur ou socle permettant d'installer un composant électronique de manière amovible sur un circuit imprimé . Un adaptateur interposé entre un composant ayant des broches et un circuit imprimé est connu du WO-A-9116740. L'adaptateur est plus particulièrement destiné aux composants utilisant la technologie des boîtiers à billes (BGA ball grid array). Les composants BGA présentent sur leur face inférieure une grille ou matrice de point de soudure en forme de sphère ou de portion de sphère. Le circuit imprimé, dans la zone destinée à recevoir le composant, comporte un matrice de pastilles de contact correspondant à la grille de sphères du composant. Après la mise en place du composant électronique sur le circuit imprimé, on réalise la soudure, par exemple par passage dans un four, et les connections sont ainsi établies entre le composant et le circuit imprimé. Durant la phase de développement ou de mise au point d'un circuit, dans le cadre d'opérations de maintenance ou en cas de défaillance d'un composant, il est nécessaire de pouvoir remplacer un composant électronique monté sur le circuit imprimé. Cette opération doit pouvoir s'effectuer facilement et sans nécessiter de nouvelles soudures. Pour résoudre ce problème, on a proposé des adaptateurs comprenant deux éléments, un premier élément femelle dont la face inférieure est soudée sur le circuit imprimé et qui présente sur sa face supérieure un élément de connexion femelle. Le second élément de l'adaptateur comporte sur sa face supérieure une grille de pastille cylindrique sur laquelle un composant de type BGA peut être soudé. La face inférieure de l'élément mâle comporte des moyens de connexion mâle. Lorsque la partie supérieure de l'adaptateur est introduite sur la partie inférieure, les éléments de connexion mâle et femelle coopèrent, réalisant ainsi les contacts électriques prévus entre le composant électronique et le circuit imprimé. Ces adaptateurs présentent néanmoins certains inconvénients qui sont résumés ci-dessous. Pour compenser les défauts de planéité entre le circuit imprimé et la partie inférieure femelle de l'adaptateur, on a proposé de monter les éléments de connexion femelle de manière flottante dans le corps de l'adaptateur. Cependant, un flottement combiné à un défaut de soudure a tendance à repousser les deux éléments à souder. De ce fait la partie femelle de l'adaptateur se retrouve en position haute et la connexion avec le circuit imprimé n'est pas garantie. D'autre part, certains composants comme les microprocesseurs nécessitent de nombreuses connexions. La force appliquée sur le composant lors de l'accouplement de la partie mâle sur la partie femelle est proportionnelle au nombre de contacts; il en découle un risque d'endommager le composant lors de l'assemblage des parties mâle et femelle de l'adaptateur. Enfin, pour vérifier l'état des soudures entre le composant et la partie mâle de l'adaptateur ou entre la partie femelle et le circuit imprimé, il est nécessaire de disposer d'un dispositif à rayons X, les matériaux utilisés pour les adaptateurs étant opaques.

Le but de la présente invention est de remédier aux inconvénients mentionnés ci-dessus en proposant un adaptateur qui garantit de bonnes connexions électriques et qui permet de réduire la force nécessaire à appliquer sur le composant pour réaliser la connexion lors de l'accouplement de ses parties mâle et femelle. L'adaptateur selon l'invention se distingue à cet effet par les caractéristiques définies à la revendication 1.

L'adaptateur objet de la présente invention permet en outre de vérifier facilement l'état des soudures sans nécessiter la mise en oeuvre d'un dispositif à rayon X. D'autres avantages ressortent de la description qui suit et des revendications dépendantes.

L'invention sera décrite en référence aux dessins annexés qui représentent de façon schématique et à titre d'exemple non limitatif une forme d'exécution d'un adaptateur pour composants électroniques selon l'invention.

La figure 1 est une vue en perspective d'un adaptateur pour composants électroniques selon la présente invention.

La figure 2 est une vue de côté de la partie mâle de l'adaptateur illustré à la figure 1.

La figure 3 est une vue de côté de la partie femelle de l'adaptateur représenté à la figure 1.

La figure 4 est une vue de côté d'un élément de contact mâle à implanter dans le corps de la partie mâle de l'adaptateur.

La figure 5 est une vue en coupe partielle d'un élément de contact femelle à implanter dans le corps de la partie femelle de l'adaptateur.

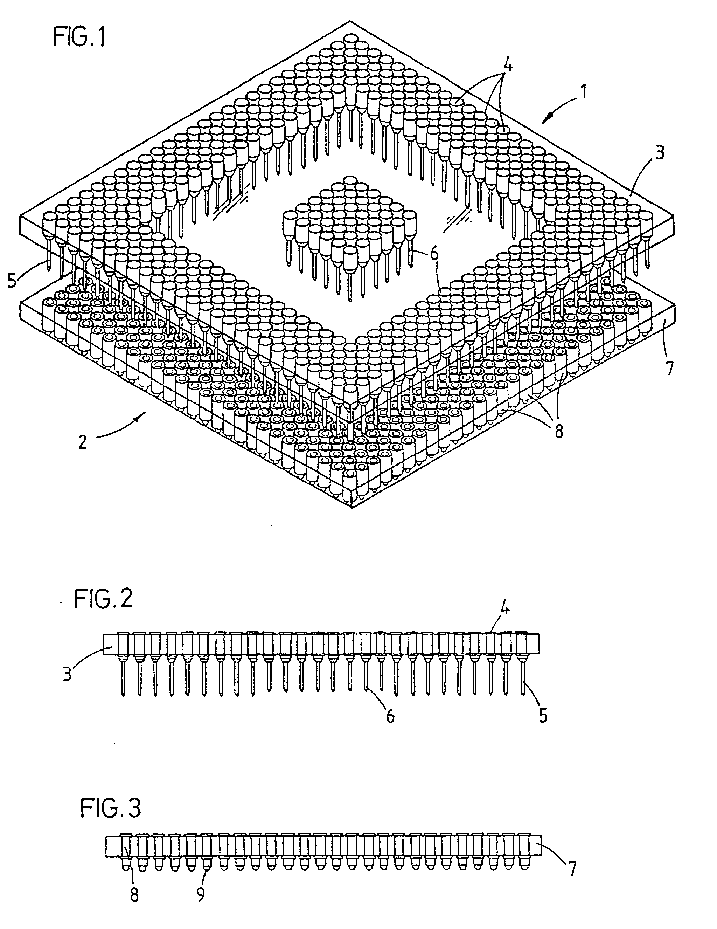

En référence à la figure 1, l'adaptateur comprend deux parties distinctes, une première partie mâle 1 destinée à recevoir le composant électronique (non représenté), et une seconde partie femelle 2 destinée à être soudée sur un circuit imprimé (non représenté). La partie mâle 1 est constituée d'un corps 3 réalisé en un matériau plastique isolant. La face supérieure de la partie mâle 1 présente une matrice ou grille de pastilles cylindriques 4. Ces pastilles cylindriques 4 correspondent dans leur alignement et leur configuration aux sphères ou portion de sphères de soudure que l'on trouve sur la face inférieure d'un composant électronique de technologie BGA. Il est ainsi possible de souder le composant électronique sur la face supérieure du corps 3. Des éléments de contact mâle 5,6 sont implantés dans le corps 3. L'extrémité supérieure de chacun des éléments de contact mâle 5 est en contact avec la pastille 4 correspondante. De cette façon on établit une connexion entre les bornes du composant et l'extrémité des éléments de contact mâle (5,6) qui font saillie de la face inférieure du corps 3. Les éléments de contact mâle 5,6 sont montés flottants dans le corps 3 de manière à compenser les éventuels défauts de planéité du composant BGA. Pour ce faire, le diamètre de l'alésage pratiqué dans le corps 3 est légèrement supérieur au diamètre de l'élément de contact 5,6. Cependant, on a constaté qu'un flottement important combiné à un défaut de soudure, dû par exemple à une mauvaise mouillabilité de la sphère du composant, a tendance à repousser les deux éléments à souder. Dans ce cas le composant électronique se trouve en position haute et la connexion entre la sphère du composant et la pastille 4 n'est pas garantie. C'est pourquoi on limite cette caractéristique à un flottement extrêmement faible. On peut citer à titre d'exemple un jeu compris entre 50 et 100 microns, de préférence 75 microns. Ce flottement très faible permet de contenir l'effet qui repousse les contacts lors de la soudure. Grâce à un flottement de cet ordre, on force la position relative des éléments à souder dans une position garantissant un bon contact électrique.

La partie inférieure femelle 2 de l'adaptateur est également constituée d'un corps 7 réalisé en un matériau plastique diélectrique identique à celui du corps 3. Elle comporte sur sa face inférieure une grille ou matrice de sphères ou de portion de sphères 9 en contact avec des éléments de contact femelle 8 implantés dans le corps 7. La face inférieure de la partie femelle est soudée sur les pastilles correspondantes d'un circuit imprimé. Pour les même raisons que celles explicitées ci-dessus, les éléments de contact femelle 8 sont montés flottants dans le corps 7. Le jeu de flottement est, comme pour la partie mâle, compris entre 50 et 100 microns, de préférence 75 microns.

On choisira de préférence un matériau plastique transparent pour la réalisation des corps 3,7 des parties mâle 1, respectivement femelle 2. Ce matériau, outre ses caractéristiques diélectriques doit également résister sans déformation et sans altération de sa transparence à des températures supérieures à celles rencontrées lors des opérations de soudure des composants. A titre d'exemple un matériau tel que le GRILAMID TR 70, vendu par la société EMS-CHEMIE AG, est parfaitement adapté. L'utilisation d'un matériau transparent, et qui reste transparent après les opération de soudure, pour la réalisation du corps de l'adaptateur permet une inspection visuelle des soudures réalisées. A l'aide d'un simple microscope, il est aisé de vérifier l'état des soudures et plus particulièrement de détecter la présence de courts-circuits. Grâce à cette caractéristique, on évite l'utilisation d'un matériel coûteux tel qu'un dispositif de contrôle à rayons X pour effectuer ces opérations de contrôle.

Il ressort de la figure 2 que certains des éléments de contact mâle 6, notamment ceux situés dans la partie centrale de la tranche de l'adaptateur, présentent une longueur plus courte que celle des éléments de contact mâle 5 situés dans les coins de l'adaptateur.

La figure 3 montre en revanche que les éléments de contact femelle 8 présentent tous des dimensions semblables.

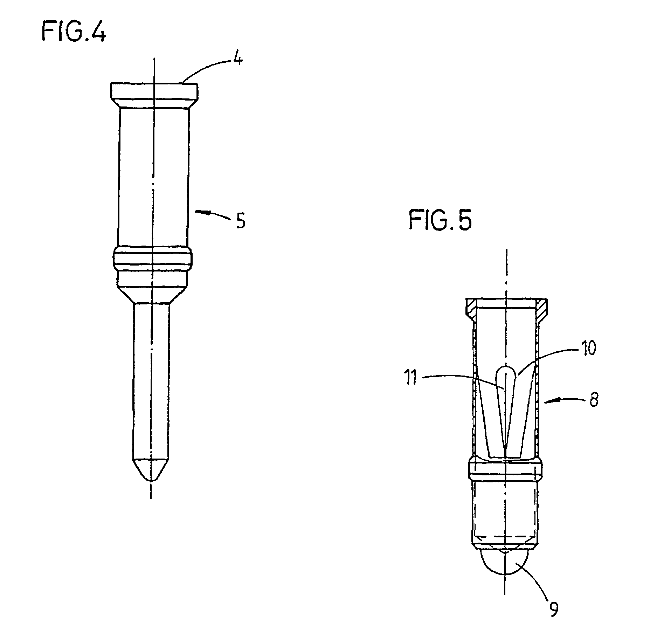

La figure 4 illustre une forme d'exécution possible parmi de nombreuses variantes d'un élément de contact mâle 5,6. Cet élément de contact comporte une partie supérieure implantée dans le corps 3 de l'adaptateur et une partie inférieure destinée à coopérer avec l'élément de contact femelle pour établir la connexion. La partie supérieure des éléments de contact mâle constitue la plaquette cylindrique 4 qui émerge du corps 3 pour recevoir le composant électronique par soudure. Ces éléments de contact mâle sont réalisés en un matériau conducteur tel que du cuivre ou un alliage de cuivre et de laiton. Ils peuvent en outre être plaqués d'une fine couche d'or par exemple.

La figure 3 illustre un élément de contact femelle 8 destiné à être implanté dans le corps 7 de l'élément femelle 2 de l'adaptateur. Cet élément de contact femelle 8 se présente sous la forme d'un corps cylindrique creux, obturé à son extrémité inférieure par une sphère de soudure 9. A l'intérieur de ce corps est agencé un clip de maintien 10 présentant sensiblement le même diamètre que le corps dans sa partie supérieure, et se rétrécissant dans sa partie inférieure. Ce clip permet de recevoir la partie saillante de l'élément de contact mâle 5,6 et de la maintenir en position de service une fois l'accouplement effectué. Ces clips 10 de type conventionnel peuvent présenter plusieurs lèvres ou fentes longitudinales 11 qui s'écartent lors de l'introduction du contact mâle 5,6. Ils sont également réalisés en un matériau assurant une bonne conductibilité et peuvent présenter un traitement de surface facilitant l'introduction de l'élément mâle dans l'élément femelle. On citera à titre d'exemple un graissage de la partie émergeante hors du corps des éléments contacts mâles, ainsi que de l'intérieur des éléments de contact femelle (8) ou des clips (10) les équipant. Ce graissage peut être obtenu par différents procédés tels que le dépôt par sérigraphie ou par tout autre procédé connu.

Un autre problème important lié à ce type d'adaptateur découle de la force requise pour insérer la partie mâle dans la partie femelle. En effet la force nécessaire pour réaliser la connexion est déterminée par les caractéristiques mécaniques du clip 10. En prenant une valeur typique de 35 grammes par contact, la force nécessaire pour assembler les deux parties d'un adaptateur comprenant 388 connexions tel que représenté à la figure 1 avoisine les 14 kilos. Ces valeurs sont limites compte tenu des caractéristiques de résistance aux contraintes de compression des composants. Dans le cas de composants nécessitant encore plus de connexions, le risque d'endommager le composant lors de l'assemblage augmente.

Le problème de l'extraction est moins critique car la force requise pour l'extraction d'un élément de contact mâle 5,6 est sensiblement inférieure à la force nécessaire à l'insertion. D'autre part, on utilise généralement un outil d'extraction adapté, qui prend appui sur le corps de l'adaptateur et protège de ce fait le composant lors de cette opération.

Lors de l'insertion, l'effort principal se produit au moment où l'élément de contact mâle 5,6 entre en contact avec le clip 10 et écarte les lèvres de ce dernier. La force résiduelle nécessaire, une fois le clip écarté, est sensiblement plus faible. Pour diminuer la force nécessaire à l'accouplement de la partie mâle sur la partie femelle, l'adaptateur selon l'invention comprend des éléments de contact mâle 5,6 qui présentent au moins deux longueurs différentes. Ces éléments de contact mâle 5,6 coopèrent avec les éléments de contact femelle 8 lors de la connexion. On notera que les éléments de contact femelle 8 présentent tous les mêmes dimensions. Ceci permet d'établir deux niveaux de contact successifs. Comme cela ressort des figures 1 et 2, certains éléments de contact mâle 5 présentent une première longueur pour établir un premier niveau de contact, les autres éléments de contact mâle 6 présentent une deuxième longueur, moindre, pour établir un second niveau de contact.

Ainsi l'introduction de la partie mâle dans la partie femelle se fait de façon progressive. Dans un premier temps, seuls les éléments de contact mâle 5, présentant la longueur la plus importante, entrent en contact et écartent les clips 10 des éléments de contact femelle 8 correspondant. Une fois ces derniers en place, les éléments de contact mâle 6 de plus faible longueur écartent à leur tour les clips 10 des éléments de contact femelle 8. La force nécessaire à l'insertion est ainsi répartie en deux étapes. Afin d'obtenir une répartition adéquate de la force à appliquer, un pourcentage compris entre 30% et 45%, de préférence 37% des éléments de contact mâle présentent la longueur la plus faible.

Pour favoriser le centrage de la partie mâle de l'adaptateur sur la partie femelle lors de l'insertion, on agencera de préférence les éléments de contact les plus longs 5 dans les coins du corps de la partie mâle 2 de l'adaptateur. Dans une variante, les éléments de contact mâle 5 les plus longs seront répartis sur la périphérie externe de la grille de contact.

Pour des éléments de contact mâle présentant une longueur typique d'environ 3 millimètres, la différence de longueur entre les éléments de contact de premier niveau 5 et les éléments de contact 6 de second niveau est d'environ 350 microns. D'une façon générale, la différence de longueur entre les éléments de contact mâle 5 permettant d'établir le premier niveau de contact et les éléments de contact mâle 6 permettant d'établir le contact de second niveau est comprise entre 3% et 25%, de préférence entre 8% et 14% de la longueur d'un élément de contact mâle 5.

Pour réaliser la fonction d'insertion progressive de la partie mâle dans la partie femelle de l'adaptateur, il est également possible de prévoir qu'une partie des éléments de contact femelle 8 comporte des clips 10 agencés à une première distance de l'orifice d'introduction, une seconde partie des éléments de contact femelle 8 comportant des clips 10 agencés à une seconde distance, plus grande, de l'orifice d'introduction. Il va de soi que cette fonction peut être réalisée en combinant des éléments de contact mâle 5,6 présentant des longueurs différentes et des éléments de contact femelle 8 munis de clips 10 agencés à différentes distances de l'ouverture par laquelle l'élément de contact mâle pénètre. De cette façon, en cumulant les deux caractéristiques, on obtient au moins quatre niveaux de contact lors de l'accouplement.

On peut aussi prévoir plus de deux niveaux de contact, en utilisant des éléments de contact mâle présentant 3 ou 4 longueurs différentes, ce choix dépendant d'options de construction de l'adaptateur.

Il est évident que le nombre de contacts ainsi que la répartition de ces derniers sur l'adaptateur peuvent varier en fonction des composants BGA à installer et que les caractéristiques de l'adaptateur selon l'invention ne sont en rien modifiées par une géométrie différente de l'adaptateur.

La description de l'adaptateur a été faite en partant du principe que l'élément femelle 2 était celui destiné à être soudé sur le circuit imprimé et que l'élément mâle était destiné à accueillir le composant BGA. Il est évident que la situation inverse peut se présenter; on aura dans ce cas un élément mâle soudé sur le circuit imprimé et coopérant avec un élément femelle qui accueillerait sur sa face supérieure le composant électronique sans sortir du cadre de l'invention telle que revendiquée.

## Revendications

1. Adaptateur permettant de connecter un composant électronique sur un circuit imprimé de façon amovible, comprenant une première partie présentant sur sa face inférieure des moyens (9) permettant de la souder sur un circuit imprimé et une seconde partie dont la face supérieure est pourvue de moyens (4) adaptés à recevoir par soudure un composant électronique, l'une desdites parties (1) comprenant un corps (3) pourvu d'une pluralité d'éléments de contact mâle (5,6) et l'autre partie (2) comprenant un corps (7) muni d'éléments de contact femelle (8) correspondants destinés à coopérer avec les éléments de contact mâle (5,6) pour établir une connexion entre le composant électronique et le circuit imprimé, caractérisé en ce que les éléments de contact (5,6,8) sont conformés de manière à établir au moins deux niveaux de contact successifs lors de l'accouplement de la première sur la seconde partie.

2. Adaptateur selon la revendication 1, caractérisé en ce qu'une première partie des éléments de contact mâle (5) présente une première longueur, permettant d'établir un premier niveau de contact, et en ce q'une seconde partie des éléments de contact mâle (6) présente une seconde longueur, plus courte, pour établir un second niveau de contact.

3. Adaptateur selon la revendication 1, caractérisé en ce que les éléments de contact femelle (8) comportent des clips (10) destinés à accueillir les éléments de contact mâle correspondant et en ce qu'une première partie des éléments de contact femelle (8) comporte des clips (10) agencés à une première distance de l'orifice d'introduction, une seconde partie des éléments de contact femelle (8) comportant des clips (10) agencés à une seconde distance, plus grande, du dit orifice d'introduction de manière à établir au moins deux niveaux de contact successifs.

4. Adaptateur selon l'une des revendications précédentes, caractérisé en ce que la proportion des éléments de contact mâle (5) présentant la première longueur, plus importante, est comprise entre 55% et 70% pour cent du total, de préférence 63%.

5. Adaptateur selon l'une des revendications précédentes, caractérisé en ce que les éléments de contact (5,8) permettant d'établir le premier niveau de contact sont répartis sur la périphérie externe de l'adaptateur.

6. Adaptateur selon l'une des revendications précédentes, caractérisé en ce que les éléments de contact (6,8) permettant d'établir le second niveau de contact sont agencés dans la partie centrale des côtés des corps (3,7) de l'adaptateur.

7. Adaptateur selon l'une des revendications précédentes, caractérisé en ce que la différence de longueur entre les éléments de contact mâle permettant d'établir le premier niveau de contact (5) et les éléments de contact mâle (6) permettant d'établir le second niveau de contact est comprise entre 3% et 25%, de préférence entre 8% et 14% de la longueur d'un contact mâle (5).

8. Adaptateur selon l'une des revendications précédentes caractérisé en ce que les éléments de contact mâle (5,6) et femelle (8) sont implantés respectivement dans le corps (3,7) des parties mâle (1) et femelle (2) de l'adaptateur de manière flottante, le jeu de fonctionnement étant limité à des valeurs comprises entre 50 et 100 microns, de préférence 75 microns.

9. Adaptateur selon l'une des revendications précédentes, caractérisé en ce que les corps (3,7) des deux parties de l'adaptateur sont réalisés en un matériau isolant transparent.

10. Adaptateur selon l'une des revendications précédentes, caractérisé en ce que les éléments de contact mâle (5,6) et femelle (8) sont lubrifiés pour favoriser l'accouplement des parties mâles (1) et femelle (2) de l'adaptateur.

## Patentansprüche

1. Adapter, ein elektronisches Bauteil auswechselbar auf eine gedruckte Schaltung aufzustecken erlaubend, mit einem ersten Teilstück, das auf seiner Unterseite Mittel (9) aufweist, die gestatten, es auf eine gedruckte Schaltung aufzulöten, und einem zweiten Teilstück, dessen Oberseite mit Mitteln (4) versehen ist, die dazu geeignet sind, durch Lötverbindung ein elektronisches Bauteil aufzunehmen, wobei eines der benannten Teilstücke (1) einen Körper (3) umfasst, der mit einer Mehrzahl von Kontaktstiftelementen (5, 6) versehen ist, und das andere Teilstück (2) einen Körper (7) umfasst, der mit entsprechenden Kontakthülsenelementen (8) versehen ist, die dafür bestimmt sind, mit den Kontaktstiftelementen (5, 6) zusammenzuwirken, um eine Verbindung zwischen dem elektronischen Bauteil und der gedruckten Schaltung herzustellen, dadurch gekennzeichnet, dass die Kontaktelemente (5, 6, 8) so gestaltet sind, dass zumindest zwei aufeinanderfolgende Kontaktebenen hergestellt werden, wenn das erste an das zweite Teilstück angekoppelt wird.

2. Adapter nach Anspruch 1, dadurch gekennzeichnet, dass ein erster Teil der Kontaktstiftelemente (5) eine erste Länge aufweist, die es gestattet, eine erste Kontaktebene herzustellen, und dass ein zweiter Teil der Kontaktstiftelemente (6) eine zweite, geringere Länge aufweist, um eine zweite Kontaktebene herzustellen.

3. Adapter nach Anspruch 1, dadurch gekennzeichnet, dass die Kontakthülsenelemente (8) Klemmen (10) umfassen, die dazu bestimmt sind, die entsprechenden Kontaktstiftelemente zu empfangen, und dadurch, dass ein erster Teil der Kontakthülsenelemente (8) Klemmen (10) umfasst, die bei einem ersten Abstand zur Eintrittsöffnung angeordnet sind, während ein zweiter Teil der Kontakthülsenelemente (8) Klemmen (10) umfasst, die bei einem zweiten, grösseren Abstand von der benannten Eintrittsöffnung angeordnet sind, um zumindest zwei aufeinanderfolgende Kontaktebenen herzustellen.

4. Adapter nach einem der vorangehenden Ansprüche, dadurch gekennzeichnet, dass der Anteil der die erste, grössere Länge aufweisenden Kontaktstiftelemente (5) zwischen 55 % und 70 % der Gesamtzahl, bevorzugt bei 63 % liegt.

5. Adapter nach einem der vorangehenden Ansprüche, dadurch gekennzeichnet, dass die Kontaktelemente (5, 8), die die erste Kontaktebene herzustellen gestatten, auf der Peripherie des Adapters verteilt sind.

6. Adapter nach einem der vorangehenden Ansprüche, dadurch gekennzeichnet, dass die Kontaktelemente (6, 8), die die zweite Kontaktebene herzustellen gestatten, im mittleren Teil der Seiten der Körper (3, 7) des Adapters angeordnet sind.

7. Adapter nach einem der vorangehenden Ansprüche, dadurch gekennzeichnet, dass der Längenunterschied zwischen den Kontaktstifielementen, die die erste Kontaktebene (5) herzustellen gestatten, und den Kontaktstiftelementen (6), die die zweite Kontaktebene herzustellen gestatten, zwischen 3 % und 25 %, vorzugsweise zwischen 8 % und 14 % der Länge eines Kontaktstifts (5) liegt.

8. Adapter nach einem der vorangehenden Ansprüche, dadurch gekennzeichnet, dass die Kontaktstift- (5, 6) und -hülsenelemente (8) im Körper (3, 7) des Steck- (1) bzw. Hülsenteilstücks (2) des Adapters federnd eingesetzt sind, wobei das Arbeitsspiel auf Werte zwischen 50 und 100 µm und vorzugsweise auf 75 µm begrenzt ist.

9. Adapter nach einem der vorangehenden Ansprüche, dadurch gekennzeichnet, dass die Körper (3, 7) der beiden Adapterteilstücke aus einem durchsichtigen isolierenden Material gefertigt sind.

10. Adapter nach einem der vorangehenden Ansprüche, dadurch gekennzeichnet, dass die Kontaktstift- (5, 6) und -hülsenelemente (8) geschmiert sind, um das Ankoppeln des Stift- (1) und Hülsenteilstücks (2) des Adapters zu begünstigen.

## Claims

1. An adapter enabling the reversible connection of an electronic component to a printed circuit, including a first part having on its lower face means (9) which make it possible to solder the same to a printed circuit and a second part of which the upper face is provided with means (4) adapted for receiving through soldering an electronic component, one of said parts (1) including a body (3) provided with a plurality of male contact members (5, 6) and the other part (2) including a body (7) provided with corresponding female contact members (8) designed for co-operating with the male contact members (5, 6) for establishing a connection between the electronic component and the printed circuit, characterised in that the contact members (5, 6, 8) are configured in such a manner as to enable at least two successive levels of contact when coupling the first part to the second part.

2. An adapter according to claim 1, characterised in that a first part of the male contact members (5) has a first length enabling the establishment of a first level of contact and in that a second part of the male contact members (6) has a second length which is shorter, for establishing a second level of contact.

3. An adapter according to claim 1, characterised in that the female contact members (8) have clips (10) designed for receiving the corresponding male contact members and in that a first part of the female contact members (8) have clips (10) arranged at a first distance from the introduction orifice and a second part of the female contact members (8) have clips (10) arranged at a second distance, which is longer, from said introduction orifice, in such a manner as to provide at least two successive levels of contact.

4. An adapter according to one of the preceding claims, characterised in that the proportion of the male contact members (5) having the first length, which is more important, is comprised between 55 % and 70 % of total and preferably amounts to 63 % of total.

5. An adapter according to one of the preceding claims, characterised in that the contact members (5, 8) which can establish the first level of contact are distributed on the outer periphery of the adapter.

6. An adapter according to one of the preceding claims, characterised in that the contact members (6, 8) which can establish the second level of contact are arranged in the central part of the sides of the bodies (3, 7) of the adapter.

7. An adapter according to one of the preceding claims, characterised in that the difference in length between the male contact members which can establish the first level of contact (5) and the male contact members (6) which can establish the second level of contact is comprised between 3 % and 25 % and, preferably, between 8 % and 14 % of the length of a male contact (5).

8. An adapter according to one of the preceding claims, characterised in that the male contact members (5, 6) and the female contact members (8) are implanted respectively in the body (3, 7) of the male part (1) and of the female part (2) of the adapter in a floating manner, the operational clearance being limited to values comprised between 50 and 100 microns and, preferably to 75 microns.

9. An adapter according to one of the preceding claims, characterised in that the bodies (3, 7) of the two parts of the adapter are made of an insulating material which is transparent.

10. An adapter according to one of the preceding claims, characterised in that the male contact members (5, 6) and the female contact members (8) are lubricated to. promote the coupling of the male part (1) and of the female part (2) of the adapter.
